# EUROPEAN PATENT SPECIFICATION

(11) **EP 4 122 290 B1**
(45) Date of publication and mention of the grant of the patent: **04.09.2024**
(21) Application number: 21713009.5
(22) Date of filing: 19.03.2021
(51) Int. Cl.: H05B 6/06, H05B 1/02

(54) **COOKING APPLIANCE WITH AT LEAST ONE CARRYING PLATE AND METHOD FOR ASSEMBLING A VIBRATION SENSOR**
KOCHGERÄT MIT MINDESTENS EINER TRAGPLATTE UND VERFAHREN ZUR MONTAGE EINES SCHWINGUNGSSENSORS
APPAREIL DE CUISSON DOTÉ D'AU MOINS UNE PLAQUE DE SUPPORT ET PROCÉDÉ D'ASSEMBLAGE D'UN CAPTEUR DE VIBRATIONS

(30) Priority: 20.03.2020 EP 20164582
(43) Date of publication of application: 25.01.2023
(73) Proprietor: ELECTROLUX APPLIANCES AKTIEBOLAG, 105 45 Stockholm (SE)
(72) Inventor: WASINKIEWICZ, Lukasz, 91541 Rothenburg ob der Tauber (DE); NEUKAMM, Alwin, 91541 Rothenburg ob der Tauber (DE)
(74) Representative: Electrolux Group Patents
(86) International application number: PCT/EP2021/057048
(87) International publication number: WO 2021/186013

(56) References cited:
- EP-A1- 2 020 826
- EP-A1- 2 590 473
- EP-A1- 2 999 301
- EP-A2- 2 801 884

## Description

The present invention relates to a cooking appliance with at least one carrying plate adapted to receive cookware placed thereon, in particular to a cooking hob with a top plate. More specifically, the invention relates to a respective cooking appliance which comprises at least one sensing means for the detection of vibration generated when food to be cooked and/or cooking adjuvant inside of the cookware is heated up. The present invention further relates to a method for assembling a carrying plate of a cooking appliance, particularly a top plate of a cooking hob, with a vibration sensor, which carrying plate transmits vibration movements from a cookware to the vibration sensor.

Cooking processes in which food is prepared for consumption are put more and more under automatic control. For automatically controlled cooking appliances, in particular cooking hobs, vibration sensors are implemented. With said sensors the cooking progress may be better monitored, particularly when using cooking liquids, with respect to temperature increase in the food and/or of the cooking liquid.

From EP 3 413 687 A1 a method for controlling a cooking process is known, which cooking process is operated when cooking food in a cooking vessel placed on a cooking hob. A vibration sensor is arranged in the cooking hob for a detection of boiling of a cooking liquid. However, this document does not teach how to assemble said vibration sensor in order to get a best performance thereof and to get correct and unaltered measuring results.

EP 2 999 301 A1 discloses a cooking hob comprising a boiling detection function including an acceleration or vibration sensor, specifically a micro-electromechanical system (MEMS), to detect vibrations caused by bubbles forming inside a heated substance. The vibration sensor is placed between the heating zones, so that vibrations caused by substances boiling in any of the heating zones around the vibration sensor can be detected with substantially the same sensitivity. The MEMS sensor may be mounted on a printed circuit board, which may be coupled to a glass ceramic by mechanical means such as a pin or walls.

EP 2 801 884 A2 discloses a cooking hob, which is connected to at least two sensors that are configured for measuring a wave propagating in the cooking hob, in particular as a result of a boiling process, wherein a control unit of the cooking hob is configured to identify the position of the source of the wave based on the time-of-flight signals received by the at least two sensors.

EP 2 590 473 A1 discloses a cooking appliance comprising a heating unit, a control unit and a sensor unit, wherein the control unit is provided for detecting an upcoming cooking condition based on the temporal course of the signal measured by the sensor unit.

EP 2 020 826 A1 discloses an induction heating cooker, which comprises an induction heating section for heating a cooking vessel, a vibration detection section for detecting a vibration of the cooking vessel, a vibration waveform extracting section for extracting a vibration waveform of the detected vibration, and a determining section for determining a state of an object to be heated in the cooking vessel based on the vibration waveform.

It is an object of the present invention to provide a cooking appliance with at least one carrying plate and a method for assembling a vibration sensor which provide measuring results particularly well supporting automatic cooking processes.

The object is achieved for a cooking appliance with at least one carrying plate and at least one sensing means for the detection of vibrations according to the features of claim 1.

A cooking appliance according to the invention comprises at least one carrying plate adapted to receive cookware placed thereon. Said cooking appliance may be a cooking hob with a top plate. The cooking appliance further comprises at least one sensing means for the detection of vibration which is generated when food to be cooked and/or cooking adjuvant inside of the cookware is heated up. The food to be cooked and/or the cooking adjuvant may be a cooking liquid. A vibration sensor is, in particular in a detachable manner, attached to the carrying plate, which may be the top plate of the cooking hob, by way of fixation means which prevent relative movement between the vibration sensor and the carrying plate, in particular in the direction towards and/or away from each other. The fixation means comprises a first rigid frame part, which is rigidly connected to the carrying plate. Particularly, the first rigid frame part is made of plastic, which may be a cost-saving solution both in relation to material costs and as serving also as electrically isolating means. The vibration sensor, or the electronic circuit board comprising the vibration sensor, respectively, is bordered on all sides by the first rigid frame part. With such kind of all-side delimitation unfavourable relative movements are yet further eliminated.

The cooking appliance may also be an oven comprising a baking tray which receives cookware placed thereon. In this alternative embodiment, the vibration sensor is attached to the baking tray for sensing vibration at or inside said cookware.

The vibration sensor may be attached to a bottom side of the carrying plate, particularly of the top plate of the cooking hob or the baking tray inside the oven. The vibration sensor is arranged preferably in a centre region of the carrying plate.

In a specific embodiment, the vibration sensor is arranged on an electronic circuit board. This may be an advantageous solution for supporting the vibration sensor in a best way to prevent a relative movement thereof.

The first rigid frame part may be circumferentially connected to the carrying plate in order to prevent its twisting during occurrence of vibrations, what also may cause negatively influencing relative movements.

Advantageously, a second rigid frame part is connected to the first rigid frame part and the vibration sensor, or particularly the electronic circuit board comprising the vibration sensor, is clamped between the first and the second rigid frame parts. Preferably the first and the second rigid frame parts are connected with each other by way of snapping means.

In a preferred embodiment, a sealing frame part is positioned between the electronic circuit board and the first rigid frame part and/or between the electronic circuit board and the second rigid frame part. The sealing frame part is preferably made of a soft and/or flexible material, e. g. a rubber material or silicone. With such soft and/or flexible material a further increased free of clearance assembling may be realized.

In particular, the vibration sensor and/or an electronic circuit board comprising or carrying the vibration sensor is connected to a data bus of the cooking appliance. For this purpose preferably a communication cable is used, which may be connected to any element that can receive a data bus communication signal, for example a user interface unit or a power board of the cooking appliance.

Particularly, the vibration sensor and/or an electronic circuit board comprising or carrying the vibration sensor may be connected to a control unit and/or to a user interface unit of the cooking appliance by means of a connecting cable. The connection cable may be a MACS cable or any other cable, e. g. a cable used for a serial or parallel bus connection.

Advantageously, the carrying plate comprises a base plate and at least one pan support placed thereon. With this, gas burners can be used on the carrying plate.

The object is achieved for a method for assembling a vibration sensor to a carrying plate of a cooking appliance according to the features of claim 9.

According to a further aspect of the invention, a method for assembling a vibration sensor to a carrying plate of a cooking appliance is disclosed. Said carrying plate may be a top plate of a cooking hob. The carrying plate transmits vibration movements from a cookware to the vibration sensor. The assembly comprises the assembling steps:
- a first rigid frame part is rigidly connected to the carrying plate, preferably in a first assembling step; and
- the vibration sensor is connected to the first rigid frame part in a way that prevents relative movements between vibration sensor and carrying plate, preferably in a second assembling step.

In a following assembling step, a second rigid frame part is connected to, preferably snapped into, the first rigid frame part. The vibration sensor, in particular the electronic circuit board comprising the vibration sensor, is clamped between the first and the second rigid frame parts. Preferably, the vibration sensor or the electronic circuit board, respectively, is clamped between the frame parts with a circumferential border thereof.

It is desirable to prevent any type of relative movements, but most favourably to prevent movements in the direction towards and/or away from each other.

Particularly, the vibration sensor is fitted into an electronic circuit board and, thereafter, the electronic circuit board comprising the vibration sensor is connected to the first rigid frame part. A preferred fitting method is soldering.

A preferred embodiment is characterized by a sealing frame part which is positioned between the vibration sensor or the electronic circuit board comprising the vibration sensor, respectively, and the first rigid frame part and/or between the vibration sensor or the electronic circuit board comprising the vibration sensor, respectively, and the second rigid frame part prior to the assembling step of connecting the second rigid frame part to the first rigid frame part. The sealing frame part may be connected to the vibration sensor or to the electronic circuit board comprising the vibration sensor and, in a following assembling step, the combination of sealing frame with the vibration sensor or the electronic circuit board comprising the vibration sensor is connected to or implemented into the first rigid frame part.

In a further following assembling step, a first connector of a connecting cable may be connected to the vibration sensor or to a circuitry comprising the vibration sensor and a second connector of the connecting cable may be connected to a control unit and/or to a user interface unit of the cooking appliance. The connecting cable may be attached to the carrying plate, e. g. by way of gluing, in order to avoid its tear-off.

Novel and inventive features of the present invention are set forth in the appended claims.

The present invention will be described in further detail with reference to the drawings, in which
- FIG 1: is an exploded view of a cooking hob illustrating components and modules arranged therein;
- FIG 2: is an exploded view of a sensor arrangement illustrating a sensor circuit board and fixation frame parts;
- FIG 3: illustrates a cross-sectional view of the sensor arrangement of FIG 2 attached to a top plate of the cooking hob; and
- FIG 4: illustrates a cooking hob with a carrying plate comprising a base plate and pan support.

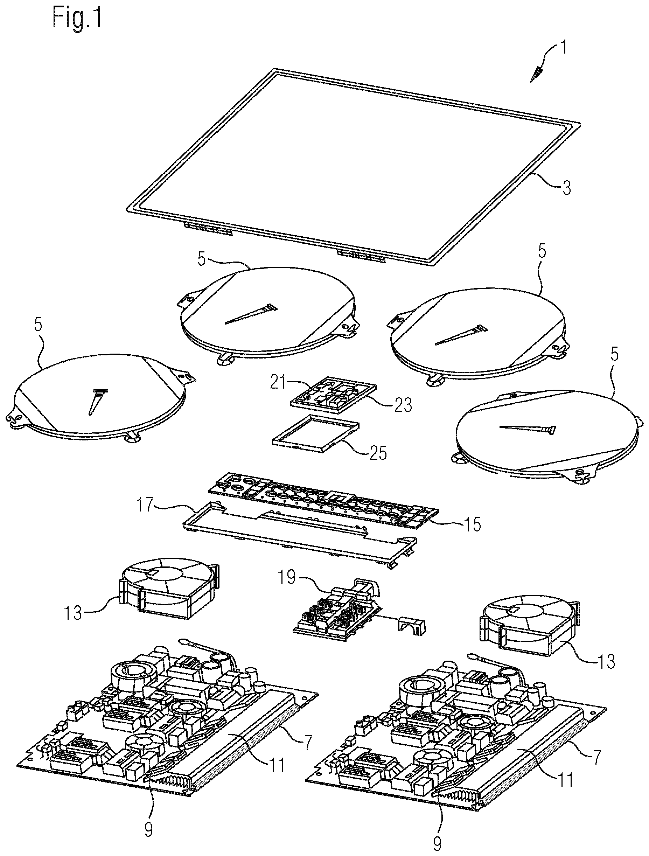

According to the illustration of FIG 1, a cooking hob 1, which is in this embodiment an induction cooking hob, but could also be a gas or radiant hob, comprises a top plate 3, the upper side thereof facing a user of the induction cooking hob who can place cookware thereon for cooking processes. The top place 3 is usually composed of glass ceramic material and cooking zones are usually indicated thereon (not shown). Four cooking zones are defined by respective induction coil arrangements 5 positioned beneath the top plate 3.

The induction coils 5 are powered by means of two power boards 7 having identical structure and comprising a number of different electric and electronic components interconnected by a circuitry. In order to provide an intensified cooling effect on power electronic components 9, also integrated in the power board circuitry, a metallic cooling channel 11 is placed on each power board 7 and the power electronic components 9 of each power board 7 are attached to the outer surface of the allocated cooling channel 11. The intensified cooling effect is further increased by means of a cooling fan 13 for each power board 7, blowing cooling air into the interior of the cooling channel 11.

The induction cooking hob 1 further comprises a user interface 15 for an input of control commands by the user which user interface 15 is attached to the bottom side of the top plate 3 by means of a user interface housing 17. All electric and electronic components are electrically supplied from the domestic power supply by means of a power cable (not shown) which is connected to a mains terminal 19 inside the induction cooking hob 1.

Finally, the induction cooking hob 1 is also equipped with a vibration sensor adapted to support a monitoring of the progress of the cooking process, especially for an automatic cooking program. Particularly cooking liquids inside of a cookware placed on the top plate 3 of the induction cooking hob 1 cause the cookware to start to vibrate at a certain temperature level, which vibration assumes a specific degree when the cooking liquid begins to boil. The start of the boiling state is sensible by said vibration sensor.

The vibration sensor is attached to the bottom surface of the top plate 3, which top plate 3 passes on the vibration signals from the cookware to the vibration sensor. In order to provide a proper arrangement of the vibration sensor and its suitable connection to a control unit arranged in the user interface 15, the sensor is arranged on a sensor printed circuit board 21 which also comprises connection means. For a firm and secure attachment the sensor printed circuit board 21 is encased by a first frame part 23 and a second frame part 25 as will be explained as follows.

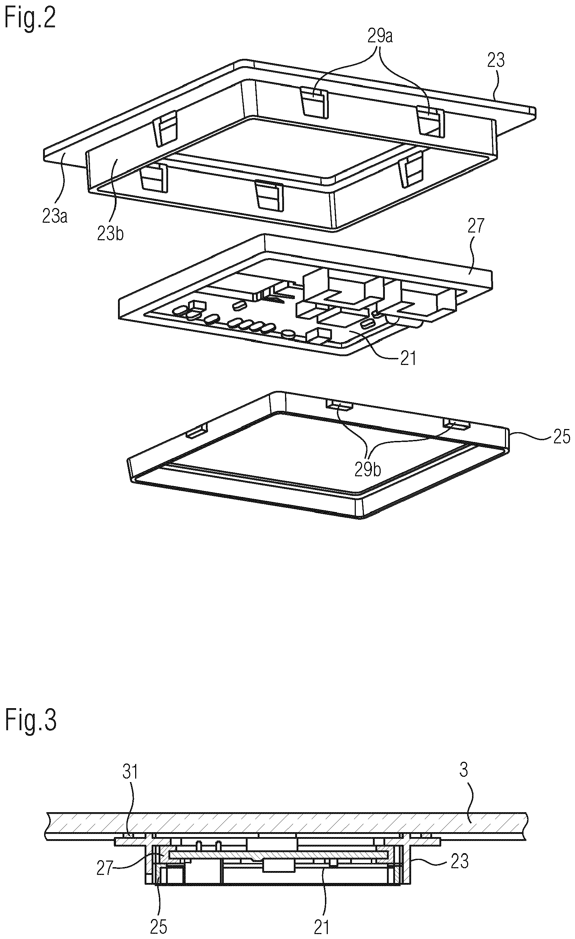

With reference to FIG 2, the arrangement of the sensor printed circuit board 21 within the first and second frame parts 23, 25 is described. As can be seen in FIG 2, a first frame part 23 is of a rectangular shape in order to receive the sensor printed circuit board 21, also being shaped rectangularly. The first frame part 23 is made of a plastic material and comprises, in its installation position, an upper, horizontal frame portion 23a which is crossed (see FIG 3) by a vertical frame portion 23b. The vertical frame portion 23b forms an outer boundary and an inner section of the horizontal frame portion 23a provides an upper stop surface for the sensor printed circuit board 21 after its integration in the first frame part 23 (see FIG 3).

The second frame part 25 is also made of a plastic material and has a rectangular shape. Its outer dimensions are adapted to the inner dimensions of the vertical frame portion 23b of the first frame part 23 in a way that the second frame part 25 is arrange-able in the interior of the vertical frame portion 23b at least without substantial clearance. After arrangement of the second frame part 25 within the vertical frame portion 23b its upper surface provides a lower stop surface for the sensor printed circuit board. In this assembling position, upper and lower stop surfaces form a sandwich-like holding mechanism for the sensor printed circuit board 21.

For a particular firm arrangement of the sensor printed circuit board 21 between first 23 and second 25 frame parts avoiding movements of these parts relative to each other, the sensor printed circuit board 21 is bordered by a sealing frame part 27 which is of a U-shaped cross section and encompasses the outer edge of the sensor printed circuit board 21 on all sides. The sealing frame part 27 is made of a soft and/or flexible material, like temperature-resistant rubber or silicone, and allows a tight clamping of the outer edge of sensor printed circuit board 21 between first 23 and second 25 frame parts. The connection of the second frame part 25 with the first frame part 23 is realized by snapping means 29a arranged at the vertical frame portion 23b and, as counterparts, by snapping means 29b arranged at the second frame part 25.

FIG 3 illustrates the installation situation of the arrangement of the sensor printed circuit board 21 between first 23 and second 25 frame parts in the induction cooking hob 1. This figure shows a cross-sectional side view of a centre region of the top plate 3. The sensor printed circuit board arrangement is attached to said centre region by means of gluing. An adhesive beading 31 between an outer section of the horizontal frame portion 23a and the bottom side of the centre region arranges for a permanent fixing of the sensor printed circuit board arrangement.

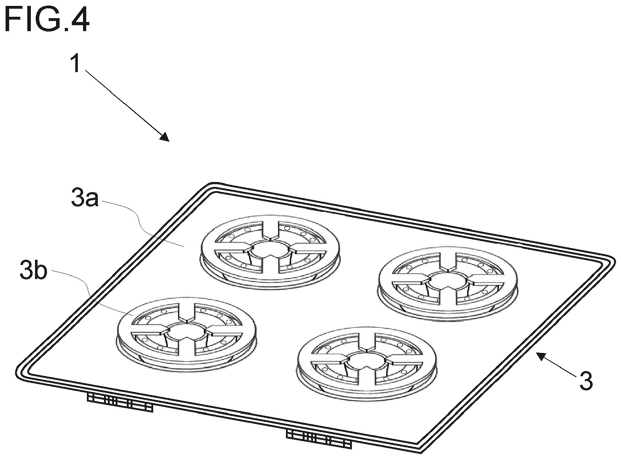

The manufacturing of the sensor printed circuit board arrangement during the assembly of the induction cooking hob 1 is as follows. First, the adhesive beading is applied on the bottom side of the centre region of the top plate 3, followed by pressing the first frame part 23 against the bottom side of the top plate 3 until the top edge of the vertical frame portion 23b rests on the bottom surface of the top plate 3. In that position, the adhesive beading is also applied on the upper surface of the outer section of the horizontal frame portion 23a, thus realizing a permanent bonded joint between first frame part 23 and top plate 3. Only thereafter, the sensor printed circuit board 21 is implemented in the first frame part 23 and the mounting of the second frame part 25 finalizes the assembling. FIG 4 illustrates another embodiment, in which the carrying plate/ top plate 3 is a system comprising a base plate 3a and at least one pan support 3b placed thereon.

Although an illustrative embodiment of the present invention has been described herein with reference to the accompanying drawing, it is to be understood that the present invention is not limited to that precise embodiment, and that various other changes and modifications may be affected therein by one skilled in the art without departing from the scope of the invention. All such changes and modifications are intended to be included within the scope of the invention as defined by the appended claims.

### List of reference numerals

- 1: induction cooking hob
- 3: top plate
- 3a: base plate
- 3b: pan support
- 5: induction coils arrangement
- 7: power board
- 9: power electronic component
- 11: cooling channel
- 13: cooling fan
- 15: user interface
- 17: user interface housing
- 19: mains terminal
- 21: sensor printed circuit board
- 23: first frame part
- 23a: horizontal frame portion
- 23b: vertical frame portion
- 25: second frame part
- 27: sealing frame part
- 29a,b: snapping means
- 31: adhesive beading

## Claims

1. A cooking appliance with at least one carrying plate (3) adapted to receive cookware placed thereon, in particular a cooking hob (1) with a top plate, and at least one sensing means for the detection of vibration generated when food to be cooked and/or cooking adjuvant inside of the cookware is heated up, the food to be cooked and/or cooking adjuvant in particular being a cooking liquid, wherein a vibration sensor is, in particular detachably, attached to the carrying plate (3) by way of fixation means which prevent relative movement between the vibration sensor and the carrying plate (3), in particular in the direction towards and/or away from each other,
**characterized in that**
the fixation means comprise a first rigid frame part (23), particularly a plastic frame part, the first rigid frame part (23) being rigidly connected to the carrying plate (3),
wherein the vibration sensor, particularly the electronic circuit board (21) comprising the vibration sensor, is bordered on all sides by the first rigid frame part (23).

2. The cooking appliance according to claim 1, wherein the vibration sensor is attached to a bottom side of the carrying plate (3), preferably in a centre region thereof.

3. The cooking appliance according to claim 1 or 2, wherein the vibration sensor is positioned on an electronic circuit board (21).

4. The cooking appliance according to anyone of the preceding claims, wherein the first rigid frame part (23) is circumferentially connected to the carrying plate (3).

5. The cooking appliance according to anyone of the preceding claims, wherein a second rigid frame part (25) is connected to the first rigid frame part (23), preferably under use of snapping means (29a, 29b), wherein the vibration sensor, in particular the electronic circuit board (21) comprising the vibration sensor, is clamped between the first (23) and the second (25) rigid frame parts.

6. The cooking appliance according to claim 5, wherein a sealing frame part (27) is positioned between the electronic circuit board (21) and the first rigid frame part (23) and/or between the electronic circuit board (21) and the second rigid frame part (25).

7. The cooking appliance according to anyone of the preceding claims, wherein the vibration sensor and/or an electronic circuit board (21) comprising the vibration sensor is/are connected to a data bus, preferably by a communication cable, more preferably an MACS cable, to any element that can received a data bus communication such as a user interface unit or a power board of the cooking appliance.

8. The cooking appliance according to anyone of the preceding claims, wherein the carrying plate comprises a base plate (3a) and at least one pan support (3b) placed thereon.

9. A method for assembling a vibration sensor to a carrying plate (3) of a cooking appliance, particularly to a top plate of a cooking hob (1), the carrying plate (3) transmitting vibration movements from a cookware to the vibration sensor,
**characterized in that**
the assembly comprises the assembling steps:
- a first rigid frame part (23) is rigidly connected to the carrying plate (3), preferably in a first assembling step; and
- the vibration sensor is connected to the first rigid frame part (23) in a way that prevents relative movement between vibration sensor and carrying plate (3), in particular in the direction towards and/or away from each other, preferably in a second assembling step,
and wherein, in a following assembling step, a second rigid frame part (25) is connected to, preferably snapped into, the first rigid frame part (23), wherein the vibration sensor, in particular the electronic circuit board (21) comprising the vibration sensor, is clamped, particularly with a circumferential border thereof, between the first (23) and the second (25) rigid frame parts.

10. The method of claim 9, wherein the vibration sensor is fitted, particularly by soldering, into an electronic circuit board (21) and, thereafter, the electronic circuit board (21) comprising the vibration sensor is connected to the first rigid frame part (23).

11. The method according to claim 9 or 10, wherein a sealing frame part (27) is positioned between the electronic circuit board (21) and the first rigid frame part (23) and/or between the electronic circuit board (21) and the second rigid frame part (25) prior to the assembling step of connecting the second rigid frame part (25) to the first rigid frame part (23).

12. The method according to claim 11, wherein the sealing frame part (27) is connected to the electronic circuit board (21) and, in a following assembling step, the combination of the sealing frame part (27) with the electronic circuit board (21) is connected to the first rigid frame part (23).

13. The method of anyone of the claims 9 to 12, wherein, in a following assembling step, a first connector of a connecting cable is connected to the vibration sensor or to a circuitry comprising the vibration sensor and a second connector of the connecting cable is connected to a control unit and/or to a user interface (15) unit of the cooking appliance.

## Patentansprüche

1. Kochvorrichtung mit mindestens einer Tragplatte (3), die dazu geeignet ist, darauf platziertes Kochgeschirr aufzunehmen, insbesondere Kochfeld (1) mit einer Deckplatte, und mindestens einem Erfassungsmittel zur Detektion einer Vibration, die erzeugt wird, wenn ein zu garendes Lebensmittel und/oder ein Kochhilfsmittel in dem Kochgeschirr erwärmt wird, wobei das zu garende Lebensmittel und/oder der Kochhilfsmittel insbesondere eine Garflüssigkeit ist,
wobei ein Vibrationssensor, insbesondere abnehmbar, an der Tragplatte (3) mittels Befestigungsmitteln angebracht ist, die eine relative Bewegung zwischen dem Vibrationssensor und der Tragplatte (3), insbesondere in der Richtung hin zu und/oder weg von einander, verhindern,
**dadurch gekennzeichnet, dass**
die Befestigungsmittel einen ersten starren Rahmenteil (23), insbesondere einen Kunststoffrahmenteil, umfassen, wobei der erste starre Rahmenteil (23) starr mit der Tragplatte (3) verbunden ist,
wobei der Vibrationssensor, insbesondere die elektronische Leiterplatte (21), die den Vibrationssensor umfasst, auf allen Seiten durch das erste starre Rahmenteil (23) eingefasst ist.

2. Kochvorrichtung nach Anspruch 1, wobei der Vibrationssensor an einer Unterseite der Tragplatte (3), vorzugsweise in einem Mittelbereich davon, angebracht ist.

3. Kochvorrichtung nach Anspruch 1 oder 2, wobei der Vibrationssensor auf einer elektronischen Leiterplatte (21) positioniert ist.

4. Kochvorrichtung nach einem der vorhergehenden Ansprüche, wobei der erste starre Rahmenteil (23) umlaufend mit der Tragplatte (3) verbunden ist.

5. Kochvorrichtung nach einem der vorhergehenden Ansprüche, wobei ein zweiter starrer Rahmenteil (25) mit dem ersten starren Rahmenteil (23), vorzugsweise unter Verwendung von Einrastmitteln (29a, 29b), verbunden ist, wobei der Vibrationssensor, insbesondere die elektronische Leiterplatte (21), die den Vibrationssensor umfasst, zwischen den ersten (23) und den zweiten (25) starren Rahmenteil geklemmt ist.

6. Kochvorrichtung nach Anspruch 5, wobei ein abdichtender Rahmenteil (27) zwischen der elektronischen Leiterplatte (21) und dem ersten starren Rahmenteil (23) und/oder zwischen der elektronischen Leiterplatte (21) und dem zweiten starren Rahmenteil (25) positioniert ist.

7. Kochvorrichtung nach einem der vorhergehenden Ansprüche, wobei der Vibrationssensor und/oder eine elektronische Leiterplatte (21), die den Vibrationssensor umfasst, mit einem Datenbus, vorzugsweise durch ein Kommunikationskabel, stärker bevorzugt ein MACS-Kabel, mit einem beliebigen Element, das eine Datenbuskommunikation empfangen kann, wie etwa einer Benutzerschnittstelleneinheit oder einer Leistungsplatine der Kochvorrichtung, verbunden ist/sind.

8. Kochvorrichtung nach einem der vorhergehenden Ansprüche, wobei die Tragplatte eine Grundplatte (3a) und mindestens einen darauf platzierten Topfträger (3b) umfasst.

9. Verfahren zur Montage eines Vibrationssensor an einer Tragplatte (3) einer Kochvorrichtung, insbesondere an einer Deckplatte eines Kochfelds (1), wobei die Tragplatte (3) Vibrationsbewegungen von einem Kochgeschirr auf den Vibrationssensor überträgt, **dadurch gekennzeichnet, dass**
die Montage die Montageschritte umfasst:
- ein erster starrer Rahmenteil (23) wird starr mit der Tragplatte (3) verbunden, vorzugsweise in einem ersten Montageschritt; und
- der Vibrationssensor wird mit dem ersten starren Rahmenteil (23) auf eine Weise verbunden, die eine relative Bewegung zwischen dem Vibrationssensor und der Tragplatte (3), insbesondere in der Richtung hin zu und/oder weg von einander, verhindert, vorzugsweise in einem zweiten Montageschritt,
und wobei in einem folgenden Montageschritt ein zweiter starrer Rahmenteil (25) mit dem ersten starren Rahmenteil (23) verbunden, vorzugsweise darin eingerastet, wird, wobei der Vibrationssensor, insbesondere die elektronische Leiterplatte (21), die den Vibrationssensor umfasst, insbesondere mit einem umlaufenden Rand davon, zwischen den ersten (23) und den zweiten (25) starren Rahmenteil geklemmt wird.

10. Verfahren nach Anspruch 9, wobei der Vibrationssensor, insbesondere durch Löten, in eine elektronische Leiterplatte (21) eingebaut wird und anschließend die elektronische Leiterplatte (21), die den Vibrationssensor umfasst, mit dem ersten starren Rahmenteil (23) verbunden wird.

11. Verfahren nach Anspruch 9 oder 10, wobei ein abdichtender Rahmenteil (27) zwischen der elektronischen Leiterplatte (21) und dem ersten starren Rahmenteil (23) und/oder zwischen der elektronischen Leiterplatte (21) und dem zweiten starren Rahmenteil (25) vor dem Montageschritt zum Verbinden des zweiten starren Rahmenteils (25) mit dem ersten starren Rahmenteil (23) positioniert wird.

12. Verfahren nach Anspruch 11, wobei der abdichtende Rahmenteil (27) mit der elektronischen Leiterplatte (21) verbunden wird und in einem folgenden Montageschritt die Kombination aus dem abdichtenden Rahmenteil (27) mit der elektronischen Leiterplatte (21) mit dem ersten starren Rahmenteil (23) verbunden wird.

13. Verfahren nach einem der Ansprüche 9 bis 12, wobei in einem folgenden Montageschritt ein erster Verbinder eines Verbindungskabels mit dem Vibrationssensor oder mit einer Schaltung, die den Vibrationssensor umfasst, verbunden wird und ein zweiter Verbinder des Verbindungskabels mit einer Steuereinheit und/oder mit einer Benutzerschnittstellen(15)-Einheit der Kochvorrichtung verbunden wird.

## Revendications

1. Appareil de cuisson avec au moins une plaque de support (3) conçue pour recevoir une batterie de cuisine placée sur celle-ci, en particulier un plan de cuisson (1) avec une plaque supérieure, et au moins un moyen capteur pour la détection de vibrations générées lorsque de la nourriture à cuire et/ou un adjuvant de cuisson à l'intérieur de la batterie de cuisine est chauffé(e), la nourriture à cuire et/ou l'adjuvant de cuisson étant en particulier un liquide de cuisson, dans lequel un capteur de vibrations est, en particulier de manière amovible, attaché à la plaque de support (3) grâce à des moyens de fixation qui empêchent un déplacement relatif entre le capteur de vibrations et la plaque de support (3), en particulier dans la direction vers et/ou à l'écart l'un de l'autre,
**caractérisé en ce que**
les moyens de fixation comprennent une première partie de cadre rigide (23), particulièrement une partie de cadre en plastique, la première partie de cadre rigide (23) étant raccordée de manière rigide à la plaque de support (3),
dans lequel le capteur de vibrations, particulièrement la carte de circuit électronique (21) comprenant le capteur de vibrations, est bordé sur tous les côtés par la première partie de cadre rigide (23).

2. Appareil de cuisson selon la revendication 1, dans lequel le capteur de vibrations est attaché à un côté inférieur de la plaque de support (3), préférablement dans une région centrale de celle-ci .

3. Appareil de cuisson selon la revendication 1 ou la revendication 2, dans lequel le capteur de vibrations est positionné sur une carte de circuit électronique (21) .

4. Appareil de cuisson selon l'une quelconque des revendications précédentes, dans lequel la première partie de cadre rigide (23) est raccordée de manière circonférentielle à la plaque de support (3).

5. Appareil de cuisson selon l'une quelconque des revendications précédentes, dans lequel une deuxième partie de cadre rigide (25) est raccordée à la première partie de cadre rigide (23), préférablement sous l'utilisation de moyens d'encliquetage (29a, 29b), dans lequel le capteur de vibrations, en particulier la carte de circuit électronique (21) comprenant le capteur de vibrations, est serré entre la première (23) et la deuxième (25) partie de cadre rigide.

6. Appareil de cuisson selon la revendication 5, dans lequel une partie de cadre d'étanchéité (27) est positionnée entre la carte de circuit électronique (21) et la première partie de cadre rigide (23) et/ou entre la carte de circuit électronique (21) et la deuxième partie de cadre rigide (25).

7. Appareil de cuisson selon l'une quelconque des revendications précédentes, dans lequel le capteur de vibrations et/ou une carte de circuit électronique (21) comprenant le capteur de vibrations est/sont raccordé(e) (s) à un bus de données, préférablement par un câble de communication, plus préférablement un câble MACS, à n'importe quel élément qui peut recevoir une communication de bus de données tel qu'une unité d'interface utilisateur ou une carte de puissance de l'appareil de cuisson.

8. Appareil de cuisson selon l'une quelconque des revendications précédentes, dans lequel la plaque de support comprend une plaque de base (3a) et au moins un support de casserole (3b) placé sur celle-ci.

9. Procédé d'assemblage d'un capteur de vibrations à une plaque de support (3) d'un appareil de cuisson, particulièrement à une plaque supérieure d'un plan de cuisson (1), la plaque de support (3) transmettant des déplacements de vibrations d'une batterie de cuisine au capteur de vibrations, **caractérisé en ce que**
l'assemblage comprend les étapes d'assemblage :
- une première partie de cadre rigide (23) est raccordée de manière rigide à la plaque de support (3), préférablement dans une première étape d'assemblage ; et
- le capteur de vibrations est raccordé à la première partie de cadre rigide (23) d'une façon qui empêche un déplacement relatif entre le capteur de vibrations et la plaque de support (3), en particulier dans la direction vers et/ou à l'écart l'un de l'autre, préférablement dans une deuxième étape d'assemblage,
et dans lequel, dans une étape d'assemblage suivante, une deuxième partie de cadre rigide (25) est raccordée à, préférablement encliquetée dans, la première partie de cadre rigide (23), dans lequel le capteur de vibrations, en particulier la carte de circuit électronique (21) comprenant le capteur de vibrations, est serré, particulièrement avec une bordure circonférentielle de celui-ci, entre la première (23) et la deuxième (25) parties de cadre rigides.

10. Procédé selon la revendication 9, dans lequel le capteur de vibrations est ajusté, particulièrement par brasage, dans une carte de circuit électronique (21) et, ensuite, la carte de circuit électronique (21) comprenant le capteur de vibrations est raccordée à la première partie de cadre rigide (23).

11. Procédé selon la revendication 9 ou la revendication 10, dans lequel une partie de cadre d'étanchéité (27) est positionnée entre la carte de circuit électronique (21) et la première partie de cadre rigide (23) et/ou entre la carte de circuit électronique (21) et la deuxième partie de cadre rigide (25) avant l'étape d'assemblage consistant à raccorder la deuxième partie de cadre rigide (25) à la première partie de cadre rigide (23) .

12. Procédé selon la revendication 11, dans lequel la partie de cadre d'étanchéité (27) est raccordée à la carte de circuit électronique (21) et, dans une étape d'assemblage suivante, la combinaison de la partie de cadre d'étanchéité (27) avec la carte de circuit électronique (21) est raccordée à la première partie de cadre rigide (23).

13. Procédé selon l'une quelconque des revendications 9 à 12, dans lequel, dans une étape d'assemblage suivante, un premier raccord d'un câble de raccordement est raccordé au capteur de vibrations ou à un circuit comprenant le capteur de vibrations et un deuxième raccord du câble de raccordement est raccordé à une unité de commande et/ou à une unité d'interface utilisateur (15) de l'appareil de cuisson.
